(19)

Europäisches Patentamt
European Patent Office
Office européen des brevets

(11) **EP 2 805 361 B1**

(12) **EUROPÄISCHE PATENTSCHRIFT**

(45) Veröffentlichungstag und Bekanntmachung des Hinweises auf die Patenterteilung:
**15.06.2016 Patentblatt 2016/24**

(21) Anmeldenummer: **13705716.2**

(22) Anmeldetag: **17.01.2013**

(51) Int Cl.:
*H01L 35/32* (2006.01)   *H01L 35/26* (2006.01)
*H01L 35/34* (2006.01)

(86) Internationale Anmeldenummer:
**PCT/EP2013/000129**

(87) Internationale Veröffentlichungsnummer:
**WO 2013/107643 (25.07.2013 Gazette 2013/30)**

(54) **HALBLEITERELEMENT ZUM EINSATZ IN EINEM THERMOELEKTRISCHEN MODUL**

SEMICONDUCTOR ELEMENT FOR USE IN A THERMOELECTRIC MODULE

ÉLÉMENT SEMI-CONDUCTEUR POUR UTILISATION DANS UN MODULE THERMOÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.01.2012 DE 102012000763**

(43) Veröffentlichungstag der Anmeldung:
**26.11.2014 Patentblatt 2014/48**

(73) Patentinhaber: **Continental Automotive GmbH 30165 Hannover (DE)**

(72) Erfinder:
• **LIMBECK, Sigrid**
**53804 Much (DE)**
• **BRÜCK, Rolf**
**51429 Bergisch Gladbach (DE)**

(56) Entgegenhaltungen:
**WO-A2-2010/117875      US-A1- 2002 170 590
US-A1- 2006 118 158**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die vorliegende Erfindung betrifft ein Halbleiterelement zum Einsatz in einem thermoelektrischen Modul.

Ein thermoelektrisches Modul ist zur Erzeugung elektrischer Energie, z. B. aus dem Abgas einer Verbrennungskraftmaschine mittels eines Generators, geeignet. Damit ist insbesondere ein Generator zur Umwandlung thermischer Energie eines Abgases in elektrische Energie gemeint, also ein sogenannter thermoelektrischer Generator.

Das Abgas aus einer Verbrennungskraftmaschine eines Kraftfahrzeugs besitzt thermische Energie, welche mittels eines thermoelektrischen Generators in elektrische Energie umgewandelt werden kann, um beispielsweise eine Batterie oder einen anderen Energiespeicher zu füllen und/oder elektrischen Verbrauchern die benötigte Energie direkt zuzuführen. Damit wird das Kraftfahrzeug mit einem besseren energetischen Wirkungsgrad betrieben und es steht für den Betrieb des Kraftfahrzeugs Energie in größerem Umfang zur Verfügung.

Ein thermoelektrisches Modul weist zumindest eine Mehrzahl thermoelektrischer Elemente auf. Thermoelektrische Materialien sind von einer Art, dass diese effektiv thermische Energie in elektrische Energie umwandeln können (Seebeck-Effekt) und umgekehrt (Peltier-Effekt). Thermoelektrische Elemente umfassen z. B. wenigstens zwei Halbleiterelemente (p-dotiert und n-dotiert), die an ihren einander gegenüberliegenden Enden, die zu einer Heißseite beziehungsweise zu einer Kaltseite hin orientiert sind, wechselseitig mit elektrisch leitenden Brücken versehen sind. In einem thermoelektrischen Modul sind zahlreiche dieser Halbleiterelemente elektrisch in Reihe geschaltet. Damit sich die generierte Potentialdifferenz der seriellen Halbleiterelemente nicht gegenseitig aufhebt, sind stets wechselweise Halbleiterelemente mit unterschiedlichen Majoritätsladungsträgern (n-dotiert und p-dotiert) in direkten elektrischen Kontakt gebracht. Mittels eines angeschlossenen Lastwiderstands kann der Stromkreis geschlossen und somit eine elektrische Leistung abgegriffen werden.

Es ist bereits versucht worden, entsprechende thermoelektrische Module für die Anwendung in Kraftfahrzeugen, insbesondere in Personenkraftfahrzeugen, bereitzustellen. Diese waren jedoch meist sehr teuer in der Herstellung und gekennzeichnet durch einen relativ geringen Wirkungsgrad. Damit konnte noch keine Serientauglichkeit erlangt werden.

Die US 2006/0118158 A1 betrifft ein thermoelektrisches Modul und ein thermoelektrisches Material, wobei das thermoelektrische Material aus mehreren Komponenten aufgebaut ist. Die eine Komponente ist ein thermoelektrische Werkstoff, die andere Komponente soll die thermoelektrische Effektivität verbessern (also entweder die thermische oder elektrische Leitfähigkeit verringern). Dabei wird vorgeschlagen, dass der thermoelektrische Wertstoff als Nanodrähte bereitgestellt wird, wobei das thermoelektrische Material durch elektrisch isolierendes oder thermisch isolierendes Material in Form von Nanopartikeln aufgefüllt wird.

Die WO 2010/117875 A2 offenbart thermoelektrische Elemente zur Anwendung in dünnen und flexiblen Körpern (z. B. elektronisches Papier). Die hier vorgeschlagenen thermoelektrischen Elemente weisen eine Matrix aus einem Bindemittelharz auf in dem thermoelektrische Partikel verteilt sind. Die thermoelektrischen Partikel sind mit Metallpartikeln beschichtet, die eine elektrische Verbindung zwischen den thermoelektrischen Partikeln sicherstellen sollen.

Hiervon ausgehend ist es Aufgabe der hier vorliegenden Erfindung, die im Zusammenhang mit dem Stand der Technik geschilderten Probleme zumindest teilweise zu lösen. Insbesondere soll ein Halbleiterelement angegeben werden, das einen verbesserten Wirkungsgrad hinsichtlich der Umwandlung von bereitgestellter thermischer Energie in elektrische Energie bei Einsatz in einem thermoelektrischen Modul ermöglicht. Dabei soll auch die einzusetzende Menge an kostenintensivem Halbleitermaterial berücksichtigt werden. Weiterhin soll ein Verfahren zur Herstellung eines thermoelektrischen Moduls angegeben werden, das möglichst einfach durchzuführen ist und ein thermoelektrisches Modul erzeugt, das gegenüber wechselnden Temperaturpotentialen, insbesondere bei Einsatz in einem Kraftfahrzeug, dauerhaft einsetzbar ist.

Diese Aufgaben werden gelöst mit einem Halbleiterelement gemäß den Merkmalen des Patentanspruchs 1. Vorteilhafte Ausgestaltungen des erfindungsgemäßen Halbleiterelements sind in den abhängig formulierten Patentansprüchen angegeben. Die in den Patentansprüchen einzeln aufgeführten Merkmale können in beliebiger, technologisch sinnvoller, Weise miteinander kombiniert werden und weitere Ausgestaltungen der Erfindung aufzeigen. Damit ist insbesondere gemeint, dass die auf das Halbleiterelement gerichteten Erläuterungen gleichermaßen für das angeführte thermoelektrische Modul wie auch für das Verfahren zur Herstellung eines rohrförmigen thermoelektrischen Moduls anwendbar sind. Die Beschreibung, insbesondere im Zusammenhang mit den Figuren, erläutert die Erfindung weiter und führt ergänzende Ausführungsbeispiele der Erfindung an.

Das Halbleiterelement ist zum Einsatz in einem thermoelektrischen Modul vorgesehen. Das Halbleiterelement weist einander gegenüberliegende Enden auf und ist aus einem n-dotierten oder p-dotierten Halbleitermaterial und mindestens einem Fremdmaterial gebildet. Das Fremdmaterial ist mit dem Halbleitermaterial vermischt. Das Fremdmaterial bildet einen Anteil von 5 Vol.-% bis 75 Vol.-% [Volumenprozent] an dem Halbleiterelement. Insbesondere bildet das Fremdmaterial einen Anteil von 25 Vol.-% bis 75 Vol.-%, bevorzugt einen Anteil von 50 Vol.-% bis 75 Vol.-% und besonders bevorzugt einen Anteil von 60 Vol.-% bis 75 Vol.-% an dem Halbleiterelement.

Als Halbleitermaterial kommt insbesondere einer der folgenden Werkstoffe zum Einsatz:

| Typ: | Material: |
|---|---|
| V-VI | $Bi_2Te_3$ |
| IV-VI | PbTe |
| $Zn_4Sb_3$ | $Zn_4Sb_3$ |
| Silizide | $p\text{-}MnSi_{1.73}$ |
|  | $n\text{-}Mg_2Si_{0.4}Sn_{0.6}$ |
|  | $Si_{0.80}Ge_{0.20}$ |
|  | $Si_{0.94}Ge_{0.06}$ |
| Skutterutide | CoSb3 |
|  |  |
| Halb-Heusler | TiNiSn |
| n/p-Klathrate | $Ba_8Ga_{16}Ge_{30}$ |
| Oxide | $p\text{-}NaCO_2\,O_4$ |
| Zintl-Phasen | $p\text{-}Yb_{14}MnSb_{11}$ |
| $Th_3P_4$ | $La_{3\text{-}x}Te_4$ |

Das Fremdmaterial ist insbesondere in das Halbleiterelement integriert und/oder eingearbeitet. Das Fremdmaterial bildet bevorzugt einen fest verbundenen und/oder einen unverlierbaren Bestandteil des Halbleiterelements. Das Füllmaterial ist mit dem Halbleitermaterial insbesondere gleichmäßig vermischt, so dass eine homogene Verteilung des Fremdmaterials in dem Halbleitermaterial vorliegt. Dabei ist jedoch zu berücksichtigen, dass das Fremdmaterial nicht in der gleichen Korngröße wie das Halbleitermaterial und ggf. in anderer äußerer Form/Gestalt (z. B. Faser) vorliegt. Entsprechend bezieht sich der Begriff "homogen" darauf, dass zumindest die überwiegende Mehrheit oder alle Teilvolumina des Halbleiterelements (z. B. bis zu einer Teilung des Halbleiterelements von 1 : 10) eine im Wesentlichen gleiche Verteilung der Anteile an Fremdmaterial und Halbleitermaterial aufweisen.

Gemäß einer vorteilhaften Ausgestaltung des Halbleiterelements weist das mindestens eine Fremdmaterial in einem Temperaturbereich von 20 °C bis 600 °C zumindest eine Eigenschaft aus der folgenden Gruppe auf:

- höhere Zugfestigkeit $R_m$ und/oder Streckgrenze $R_{p0,2}$ als das Halbleitermaterial,
- geringere spezifische Wärmeleitfähigkeit [Watt/(Kelvin * Meter)] als das Halbleitermaterial,
- geringere elektrische Leitfähigkeit [Ampere/ (Volt * Meter)] als das Halbleitermaterial.

Bevorzugt ist weiter, dass mehrere oder alle dieser Eigenschaften vorliegen.

Die Eigenschaft unterstützt die gewünschten Funktionen des Halbleiterelements, wie z. B. die Verbesserung der Zugfestigkeit, eine (ggf. lokal vorgegebene oder angepasste) Wärmeleitfähigkeit und/oder eine angepasste elektrische Leitfähigkeit, wobei die letzten Eigenschaften insbesondere zur Verbesserung des Wirkungsgrades des thermoelektrischen Materials eingesetzt werden können.

Insbesondere ist vorgesehen, dass das Fremdmaterial hier als thermisches Isolationsmaterial innerhalb des Halbleiterelements angeordnet ist.

Insbesondere ist vorgesehen, dass das Fremdmaterial nicht als elektrischer Leiter eingesetzt wird, hier also keine Funktion des thermoelektrischen Materials (Seebeck-/Peltier-Effekt) übernimmt. Insbesondere wird der thermoelektrische Effekt ausschließlich durch das Halbleitermaterial in dem Halbleiterelement bewirkt.

Insbesondere ermöglicht der Einsatz des Fremdmaterials innerhalb des Halbleiterelements, dass die Wärmeleitfähigkeit eines mit entsprechenden Halbleiterelementen aufgebauten thermoelektrischen Moduls bei einem Betriebspunkt so eingestellt ist, dass zwischen 30 % und 70 %, insbesondere zwischen 40 % und 60 %, der Gesamttemperaturdifferenz (zwischen einem Abgas und einem Kühlmittel) über dem thermoelektrischen Modul, also zwischen einer Heißseite und einer Kaltseite, abfällt.

Die Halbleiterelemente weisen an ihren der Heißseite sowie der Kaltseite zugewandten Enden jeweils eine Stirnfläche auf, mit der sie mit der Heißseite bzw. mit der Kaltseite wärmeleitend kontaktiert sind. Dabei kommt es nicht darauf an, dass die jeweiligen Enden z. B. mit elektrischen Leiterelementen versehen sind, oder dass die elektrischen Leiterelemente gegenüber der Heißseite bzw. Kaltseite eine zusätzliche elektrische Isolierung aufweisen. Hier ist die flächige Abdeckung der Kaltseite und/oder Heißseite durch die jeweilige Stirnfläche der Halbleiterelemente von Bedeutung, weil diese Flächenbeaufschlagung gleichzeitig den Raumausnutzungsgrad bzw. Flächennutzungsgrad der Heißseite bzw. Kaltseite bzw. des zwischen dieser Heißseite und Kaltseite vorliegenden Zwischenraums beschreibt.

Mit anderen Worten heißt das auch, dass an den jeweiligen Enden der Halbleiterelemente jeweils eine Querschnittsfläche innerhalb des Halbleiterelements vorliegt, die zu höchstens 95 %, insbesondere zu höchstens 75 %, bevorzugt zu höchstens 60 %, besonders bevorzugt zu höchstens 50 % und ganz besonders bevorzugt zu höchstens 25 % durch das Halbleitermaterial gebildet ist.

Die Heißseite und Kaltseite begrenzen den für die Anordnung der Halbleiterelemente verfügbaren Zwischenraum innerhalb des thermoelektrischen Moduls. Heißseite und Kaltseite sind insbesondere durch Abschlusselemente verbunden, so dass der Zwischenraum insbesondere durch Heißseite, Kaltseite und Abschlusselemente umschlossen und gebildet wird. Bisher ist davon ausgegangen worden, dass eine möglichst hohe Raumausnutzung dieses Zwischenraums bzw. eine möglichst hohe Flächenausnutzung auf der Heißseite bzw. Kaltseite durch thermoelektrisches Material erforderlich ist, um eine hohe Umsetzung der verfügbaren thermischen Energie in elektrische Energie infolge eines thermoelektrischen Moduls bzw. thermoelektrischen Generators zu ermöglichen.

Die Raumausnutzung und die Auswahl des hier vorgesehenen Fremdmaterials orientieren sich bevorzugt (ausschließlich) nach den Anforderungen der mechanischen bzw. auch chemischen Stabilität des thermoelektrischen Moduls. Hierbei wird die Erkenntnis genutzt, dass die Raumausnutzung durch thermoelektrisches Halbleitermaterial und die Auswahl des Fremdmaterials aufeinander abgestimmt werden sollen, um die thermischen Widerstände der einzelnen funktionalen Schichten (Heißseite, Kaltseite, Halbleiterelemente) aneinander anzupassen. Durch diese spezifische Anpassung der Anordnung und Anteile von Halbleitermaterial und Fremdmaterial kann die Gesamttemperaturdifferenz zwischen dem Abgas der Heißseite und einem Kühlmittel an der Kaltseite leistungssteigernd durch das thermoelektrische Modul genutzt werden.

Die erzeugbare elektrische Leistung des thermoelektrischen Moduls ergibt sich vereinfacht ausgedrückt aus dem Produkt des thermoelektrischen Wirkungsgrades des Moduls und dem auf der heißeren Seite des thermoelektrischen Moduls eintretenden Wärmestrom Q. Im Allgemeinen steigt der thermoelektrische Wirkungsgrad mit steigendem thermischem Widerstand der funktionalen Schicht zwischen der Heißseite und der Kaltseite, da dadurch die Temperaturdifferenz zwischen der Heißseite und der Kaltseite steigt. Dem entgegen sinkt der fließende Wärmestrom durch den erhöhten thermischen Widerstand. Das bedeutet insbesondere, dass die elektrische Leistung eine Funktion des thermischen Widerstands des thermoelektrischen Moduls ist. Der thermische Widerstand des thermoelektrischen Moduls ergibt sich aus der Wärmeleitfähigkeit des Halbleiterelements (hier also Halbleitermaterial und Fremdmaterial), den geometrischen Abmessungen der Halbleiterelemente, der Wärmeleitfähigkeit der zwischen den Halbleiterelementen angeordneten elektrischen Isolation sowie deren geometrischen Abmessungen. Demnach gilt unter Vernachlässigung thermischer Kontaktwiderstände für den thermischen Widerstand des Moduls ($R_{Modul}$) folgende Beziehung:

$$R_{Modul} = x \, / \, (\lambda_{TE} * A_{TE} + \lambda_{Isolation} * A_{Isolation}),$$

mit

| | |
|---|---|
| x: | Höhe des thermoelektrischen Moduls, d. h. dem Abstand zwischen der Heißseite und der Kaltseite des thermoelektrischen Moduls, |
| $\lambda_{TE}$: | Wärmeleitfähigkeit der Halbleiterelemente, |
| $\lambda_{Isolation}$: | Wärmeleitfähigkeit der elektrischen Isolation, |
| $A_{TE}$: | Fläche der Halbleiterelemente senkrecht zum Wärmestrom (insbesondere Querschnitt durch die Halbleiterelemente), |
| $A_{Isolation}$: | Fläche der elektrischen Isolation senkrecht zum Wärmestrom (insbesondere Querschnitt durch elektrische Isolation). |

Der konvektive Widerstand ($R_{konvektiv}$) ergibt sich zu

$$R_{konvektiv} = 1 \, / \, (\alpha * A)$$

wobei a den Wärmeübergangskoeffizienten und A die entsprechende betrachtete Oberfläche angibt. Die kleinste Flächeneinheit $A_{EZ}$, die hier für den Vergleich von $R_{konvektiv}$ und $R_{Modul}$ betrachtet wird, entspricht der Querschnittsfläche einer sogenannten Einheitszelle. Die Einheitszelle umfasst den Bereich eines thermoelektrischen Moduls, der jeweils ein n- und p-dotiertes Halbleiterelement und die dazwischen angeordnete elektrische Isolation umfasst. Damit gilt:

$$A_{TE} + A_{Isolation} = A_{EZ}$$

Die vorhandene Gesamttemperaturdifferenz zwischen z. B. einem auf der Heißseite vorbeiströmenden Abgas und einem auf der Kaltseite vorbeiströmenden Kühlmittel teilt sich im Verhältnis der thermischen Einzelwiderstände $R_{Konvektiv}$ (jeweils für die Heißseite und für die Kaltseite) und $R_{Modul}$ auf. Die damit zwischen der Heißseite und der Kaltseite des thermoelektrischen Moduls vorliegende Temperaturdifferenz verhält sich entsprechend proportional zum thermischen Widerstand des thermoelektrischen Moduls $R_{Modul}$. Der durch die Halbleiterelemente in elektrischen Strom umwandelbare Wärmestrom Q ergibt sich damit entsprechend aus den Verhältnissen dieser Widerstände $R_{konvektiv}$ und $R_{Modul}$ zueinander und verhält sich umgekehrt proportional zu $R_{Modul}$. Weitere Wärmeströme in dem thermoelektrischen Element sind der Peltierwärmestrom und der Ohm' sche Wärmestrom, der durch den Ohm' schen Widerstand der Halbleitermaterialien der thermoelektrischen Elemente hervorgerufen wird.

Der über das thermoelektrische Modul fließende Wärmestrom Q errechnet sich entsprechend aus dem Quotienten $\Delta T/R_{Modul}$, wobei $\Delta T$ die Temperaturdifferenz zwischen der Heißseite ($T_{h, TM}$) und der Kaltseite ($T_{k, TM}$) und $R_{Modul}$ den thermischen Widerstand des thermoelektrischen Moduls angibt. Damit kann die erzeugbare elektrische Leistung des thermoelektrischen Moduls durch den thermischen Widerstand des thermoelektrischen Moduls wesentlich beeinflusst werden. Über die Halbleiterelemente fließt in Abhängigkeit von den Eigenschaften des Halbleitermaterials und des Fremdmaterials ein Wärmestrom von der Heißseite zur Kaltseite. Je höher die spezifische Wärmeleitfähigkeit des Halbleiterelements ist, umso geringer ist die für die elektrische Stromerzeugung verfügbare Temperaturdifferenz zwischen dem an der Heißseite und dem an der Kaltseite angeordneten Ende des Halbleiterelementes. Die Erfindung hat nun eine signifikante Anpassung vorgenommen zwischen einerseits dem für die Stromerzeugung wichtigen Halbleitermaterial, das die Heißseite mit der Kaltseite zum einen zur Stromerzeugung aus der Temperaturdifferenz aber zum anderen eben auch wärmeleitend miteinander verbindet, und andererseits einer verbesserten Wärmeisolierung zwischen Heißseite und Kaltseite (z. B. durch das Fremdmaterial), so dass eine große Temperaturdifferenz an den jeweiligen Enden der Halbleiterelemente an der Heißseite bzw. an der Kaltseite vorliegt und gleichzeitig ein großer Wärmestrom über die Halbleiterelemente von der Heißseite zur Kaltseite des thermoelektrischen Moduls fließt.

Nunmehr wird hier insbesondere vorgeschlagen, dass der Zwischenraum zwischen Heißseite und Kaltseite nun nicht mehr möglichst vollständig durch Halbleitermaterial ausgefüllt ist, sondern im Gegenteil ein großer Teil, der an der Heißseite bzw. Kaltseite für Halbleiterelemente verfügbaren Fläche bzw. des zwischen Heißseite und Kaltseite vorliegenden Zwischenraumes insbesondere durch thermisch isolierendes und thermoelektrisch inaktives Fremdmaterial aufgefüllt wird. Insbesondere ist das übrige (geringe) Volumen des Zwischenraums zwischen den Halbleiterelementen durch elektrische Isolationen ausgefüllt.

Die Wärmeleitfähigkeit des thermoelektrischen Moduls bei einem (vorgegebenen) Betriebspunkt des thermoelektrischen Moduls wird durch den vorbestimmten Anteil an Fremdmaterial so eingestellt, dass zwischen 40 % und 60 % der Gesamttemperaturdifferenz zwischen z. B. einem auf der Heißseite vorbeiströmenden Abgas und einem auf der Kaltseite vorbeiströmenden Kühlmittel über dem thermoelektrischen Modul (also zwischen Heißseite und Kaltseite) abfällt. Das bedeutet mit anderen Worten auch, dass für einen vorbestimmten Betriebspunkt des thermoelektrischen Moduls die Summe der konvektiven Widerstände $R_{konvektiv}$ der Heißseite und der Kaltseite des thermoelektrischen Moduls zwischen 80 % und 120 % des Wertes des thermischen Widerstands des thermoelektrischen Moduls $R_{Modul}$ beträgt.

Mit steigendem thermischen Widerstand des thermoelektrischen Moduls erhöht sich die für die Stromerzeugung nutzbare Temperaturdifferenz zwischen Heißseite und Kaltseite des thermoelektrischen Moduls. Der thermoelektrische Wirkungsgrad profitiert näherungsweise linear von einer steigenden Temperaturdifferenz. Dafür sinkt jedoch der fließende Wärmestrom durch das thermoelektrische Modul, da sich mit steigendem thermischen Widerstand des thermoelektrischen Moduls auch der Gesamtwiderstand (Summe aus $R_{konvektiv}$ und $R_{Modul}$) erhöht. Es gibt somit ein Leistungsmaximum der Gesamtanordnung in Abhängigkeit des thermischen Widerstands. Näherungsweise kann man ansetzen, dass die elektrische Leistung maximal ist, wenn die Hälfte der Gesamttemperaturdifferenz (Abgas/Kühlmittel) über dem thermoelektrischen Modul abfällt. D. h. es sollte in etwa gelten:

$$R_{konvektiv - Heißseite} + R_{konvektiv - Kaltseite} = R_{Modul}$$

Der thermische Widerstand des thermoelektrischen Moduls kann unter anderem über den Anteil an Fremdmaterial in den Halbleiterelementen eingestellt werden. Die Einstellung des thermischen Widerstands des thermoelektrischen Moduls kann auch durch nicht konstante Querschnitte der Halbleiterelemente und/oder durch poröse Halbleiterelemente erreicht werden. Der Anteil an Halbleitermaterial in dem Zwischenraum des thermoelektrischen Moduls wird im Folgenden als Füllgrad bezeichnet. Ist der gesamte für den Einbau von Halbleiterelementen verfügbare Zwischenraum zwischen Heißseite und Kaltseite von Halbleitermaterial ausgefüllt, beträgt der Füllgrad 1 oder 100 %. Ist nur die Hälfte des genannten Zwischenraums durch Halbleitermaterial ausgefüllt, beträgt der Füllgrad 0,5 oder 50 %. Wird als elektrische Isolation zwischen Halbleiterelementen, die in der folgenden Betrachtung zu 100 % aus Halbleitermaterial bestehen, z. B. Luft eingesetzt, ist bei einer Anordnung mit einem Füllgrad von 0,5 der thermische Widerstand des thermoelektrischen Moduls ungefähr doppelt so groß wie bei einem Füllgrad von 1. Die Ursache liegt in der kleineren verfügbaren Fläche, durch den der Wärmestrom fließen kann. Durch den Füllgrad lässt sich der thermische Widerstand des thermoelektrischen Moduls so einstellen, dass ein Höchstmaß an elektrischer Leistung erzeugt werden kann. D. h. es wird wesentlich weniger (teures) thermoelektrisches Material benötigt und gleichzeitig die elektrische Leistung durch die Einstellung des thermischen Widerstands des thermoelektrischen Moduls erhöht.

Simulationen haben diese Erkenntnisse bestätigt. Ein exemplarisches Ergebnis ist in der folgenden Tabelle gezeigt:

Tabelle 1: Simulationsergebnisse für eine Füllgradvariation

| Füllgrad | Isolations-material | $\lambda_{eff}$ | $T_{h, TM}$ | $T_{k, TM}$ | $Q_{Parasitär}$ | $Q_{TM}$ | Wirkungsgrad | $P_{el}$ |
|---|---|---|---|---|---|---|---|---|
| [-] | [-] | [W/mK] | [°C] | [°C] | [W] | [W] | [-] | [W] |
| 0,9 | Luft | 1,2 | 164 | 95 | 0,006 | 1,92 | 1,52 | 0,029 |
| 0,66 | Luft | 0,9 | 183 | 95 | 0,025 | 1,81 | 1,83 | 0,034 |
| 0,3 | Luft | 0,5 | 240 | 95 | 0,092 | 1,42 | 2,51 | 0,038 |

Es ist zu erkennen, dass mit abnehmendem Füllgrad die effektive Wärmeleitfähigkeit ($\lambda_{eff}$) sinkt. Die effektive Wärmeleitfähigkeit beschreibt hier einen Ersatzwert für eine Einheitszelle, die aus dem parallelen Pfad des Halbleiterelementes (hier zu 100 % bestehend aus Halbleitermaterial) und der elektrischen Isolation besteht. Also gilt:

$$(\lambda_{TE} * A_{TE} + \lambda_{Isolation} * A_{Isolation}) / (A_{TE} + A_{Isolation}) = \lambda_{eff}$$

Durch die abnehmende effektive Wärmeleitfähigkeit erhöht sich die Temperaturdifferenz über dem Modul ($T_{h, TM}$ : 164 zu 240 °C im Verhältnis zu $T_{K, TM}$: 95 °C), was wiederum einen positiven Einfluss auf den Wirkungsgrad hat (Wirkungsgrad: 1,52 zu 2,51). Dadurch ergibt sich insgesamt eine Steigerung der elektrischen Leistung ($P_{el}$) um 30 %, bei gleichzeitiger Verringerung des eingesetzten Halbleitermaterials um 66 %. Die gezeigten Ergebnisse gehen von einem vorbestimmten Betriebspunkt und einem vorbestimmten konvektiven Wärmeübergang aus. Das thermoelektrische Modul ist ebenso an spezifische Anforderungen (z. B. Unterschiede Verbrennungskraftmaschine Diesel/Otto in der Abgasenthalpie) im Betrieb anpassbar.

$Q_{Parasitär}$ ist der eintretende Anteil des Wärmestroms auf der Heißseite des thermoelektrischen Moduls, der nicht durch das Halbleitermaterial, sondern, in diesem Beispiel, durch die parallel angeordnete elektrische Isolation (hier Luft), fließt. In Bezug auf die vorliegende Erfindung umfasst $Q_{parasitär}$ den Anteil des Wärmestroms der durch das Fremdmaterial und durch die elektrische Isolation fließt.

Neben der Leistungssteigerung kann durch Variation des Parameters Füllgrad auch die Temperatur auf der Heißseite des thermoelektrischen Moduls ($T_{h, TM}$) eingestellt werden, so dass eine Überhitzung im Betrieb eines thermoelektrischen Moduls in einer Abgasanlage vermieden werden kann.

Als Betriebspunkt ist hier ein Zustand bezeichnet, für den das thermoelektrische Modul ausgelegt werden soll und der am Einbauort des thermoelektrischen Moduls im Allgemeinen vorliegt. Der Betriebspunkt umfasst z. B. Abgastemperaturen, Kühlmitteltemperaturen, Abgasmassenstrom, Kühlmittelmassenstrom usw.

Durch den Einsatz von Fremdmaterial in dem Halbleiterelement wird eine auf den Wärmefluss abgestimmte thermische Isolierung erreicht, so dass leistungsmindernde parasitäre Wärmeströme innerhalb des thermoelektrischen Moduls, parallel zum thermoelektrischen Material, minimiert werden. Durch den Einsatz des erfindungsgemäßen Halbleiterelementes kann die nutzbare elektrische Leistung durch ein entsprechend aufgebautes thermoelektrisches Modul maximiert und gleichzeitig der Einsatz an kostenintensivem Halbleitermaterial reduziert werden. Zusätzlich ergeben sich Vorteile hinsichtlich des Aufbaus des thermoelektrischen Moduls, da nun auf den Einsatz von Füllmaterial zwischen den Halbleiterelementen verzichtet werden kann.

Erfindungsgemäß liegt das Fremdmaterial in Form von Fasern und/oder Körnern vor. Eher längliche Strukturen des Fremdmaterials werden in diesem Zusammenhang als Fasern bezeichnet. Dabei liegt hier das Verhältnis von größter Dicke zu größter Länge bei mindestens 2, insbesondere mindestens 30 oder sogar bei mindestens 100. Entsprechend wird die Struktur des Fremdmaterials als Korn bezeichnet, wenn dieses Verhältnis von größter Dicke zu größter Länge kleiner als 2 ist.

Bevorzugt beträgt der Anteil von Körnern an dem Fremdmaterial zumindest 30 Vol.-%. Das bedeutet, dass höchstens 70 Vol.-% des Fremdmaterials als Fasern vorliegen. Insbesondere liegt der Anteil von Körnern an dem Fremdmaterial zumindest bei 50 % und bevorzugt bei 80 %. Besonders bevorzugt ist, dass Fremdmaterial ausschließlich in Form von Körnern vorgesehen ist.

Erfindungsgemäß sind Körner und Fasern in dem Halbleiterelement unterschiedlich verteilt, wobei Körner an den Enden des Halbleiterelements mit einem höheren Anteil als die Fasern vorliegen, und die Fasern mit einem höheren Anteil als die Körner in einem mittleren Bereich zwischen den Enden des Halbleiterelements vorliegen. Der mittlere Bereich umfasst insbesondere einen mittig zwischen den Enden des Halbleiterelementes angeordneten Bereich, der ca. 50 % der Höhe des Halbleiterelementes umfasst.

Bevorzugt ist, dass das mindestens eine Fremdmaterial zumindest teilweise in Form von Fasern vorliegt und die Fasern im Wesentlichen in mindestens einer ersten Richtung parallel zu den Enden und/oder in einer zweiten Richtung, die quer zu der ersten Richtung verläuft, angeordnet sind.

Durch die Ausrichtung der Fasern innerhalb des Halbleiterelements können gerichtete Eigenschaften des Halbleiterelements erreicht werden. Gerichtete Eigenschaft bedeutet hier, dass das Halbleiterelement z. B. in einer ersten Richtung andere Eigenschaften als in einer zweiten Richtung aufweist. Z. B. können durch eine entsprechende Auswahl und Anordnung von Fasern gerichtete Werte für Festigkeit, Zähigkeit oder Wärmeausdehnung des Halbleiterelements eingestellt werden.

Insbesondere ist vorgesehen, dass jeder parallel zu den Enden verlaufende Querschnitt des Halbleiterelements einen Anteil von Fremdmaterial aufweist, der in einem Bereich zwischen 25 % und 75 % liegt, wobei bevorzugt vorgesehen ist, dass dieser Anteil von Fremdmaterial in einem Bereich zwischen 50 % und 75 % liegt und besonders bevorzugt zwischen 60 % und 75 %.

Der Einsatz des Fremdmaterials in dem Halbleiterelement ersetzt somit insbesondere auch das vorher als (externes und/oder separates) Füllmaterial zwischen Halbleiterelementen eingesetzte, keine thermoelektrischen Eigenschaften aufweisende Material (elektrische Isolation). Dadurch kann bereits durch den Aufbau der Halbleiterelemente die bevorzugte Ausgestaltung eines thermoelektrischen Moduls hinsichtlich des thermischen Widerstands eingestellt werden. Die für die Stromerzeugung nutzbare Temperaturdifferenz zwischen Heißseite und Kaltseite des thermoelektrischen Moduls wird somit im Wesentlichen allein durch die Auslegung der Halbleiterelemente bestimmt. Durch das in dem Halbleiterelement eingesetzte Fremdmaterial wird entsprechend der durch das thermoelektrische Modul fließende Wärmestrom zwischen Heißseite und Kaltseite reduziert, da mit steigendem thermischen Widerstand des thermoelektrischen Moduls sich auch der Gesamtwiderstand erhöht. Entsprechend kann das Fremdmaterial, das insbesondere keine thermoelektrischen Eigenschaften aufweist, (ausschließlich) für die mechanische und ggf. chemische Stabilisierung des Halbleiterelements eingesetzt werden. Eine Reduzierung des thermoelektrischen Wirkungsgrads des Halbleiterelements wird durch den Einsatz des Fremdmaterials nicht verursacht. Überraschenderweise wird eine Verbesserung des thermoelektrischen Wirkungsgrads eines thermoelektrischen Moduls bei Einsatz dieser Halbleiterelemente erreicht. Weiterhin wird durch die Zusammenführung der funktionellen Eigenschaften von Halbleitermaterial und Fremdmaterial der Aufbau bzw. das Verfahren zur Herstellung eines thermoelektrischen Moduls entscheidend vereinfacht.

Es wird weiterhin ein thermoelektrisches Modul mit einer Heißseite und einer Kaltseite und einem dazwischen angeordneten Zwischenraum vorgeschlagen, wobei in dem Zwischenraum zumindest teilweise oder ausschließlich erfindungsgemäße Halbleiterelemente angeordnet sind. Die Halbleiterelemente sind miteinander elektrisch leitend verbunden, wobei der Zwischenraum des thermoelektrischen Moduls wenigstens zu 80 Vol.-% mit Halbleiterelementen ausgefüllt ist, insbesondere zu wenigstens 90 Vol.-% und bevorzugt zu mindestens 95 Vol.-% , besonders bevorzugt zu mindestens 99 Vol.-%.

Gemäß einer vorteilhaften Ausgestaltung des thermoelektrischen Moduls sind die jeweils benachbart zueinander angeordneten Halbleiterelemente durch ein elektrisches Isolationsmaterial mit einer Dicke von weniger als 0,5 mm [Millimeter], insbesondere von weniger als 0,1 mm und bevorzugt von weniger als 0,01 mm voneinander getrennt.

Das elektrische Isolationsmaterial kann insbesondere mit den Halbleiterelementen verbunden sein. Bspw. kann das elektrische Isolationsmaterial in Form einer Beschichtung auf das Halbleiterelement aufgetragen sein. Das elektrische Isolationsmaterial kann auch als separates Bauteil zwischen benachbart zueinander angeordneten Halbleiterelementen angeordnet werden.

Insbesondere ist das elektrische Isolationsmaterial für das thermoelektrische Modul ein Glimmermaterial.

Glimmer (Mica) sind Phyllosilikate, in welchen die Einheitsstruktur aus einem oktaedrischen Blatt (Os) zwischen zwei gegenübergesetzten tetraedrischen Blättern (Ts) bestehen. Diese Blätter bilden eine Schicht, welche von benachbarten Schichten durch Flächen nicht-hydratierter Zwischenlagen-Kationen (I) getrennt sind. Die Sequenz ist : .... I Ts Os Ts I Ts Os Ts ...... Die Ts haben die Zusammensetzung $T_2O_5$. Die koordinierenden Anionen um die oktaedrisch koordinierten Kationen (M) bestehen aus Sauerstoffatomen benachbarter Ts und Anionen A. Die Koordination der Zwischenlagen-Kationen ist nominal 12-fach, mit einer vereinfachten Formel, welche wie folgt geschrieben werden kann:

$$I\ M_{2\text{-}3}\ X_{1\text{-}0}T_4O_{10}A_2$$

wobei

I = Cs, K, Na, NH4, Rb, Ba, oder Ca
M = Li, $Fe^{++}$ oder $Fe^{+++}$ , Mg, Mn++ oder $Mn^{+++}$, Zn, Al, Cr, V, oder Ti
T = Be, Al, B, Fe+++, oder Si
A = Cl, F, OH, O (Oxy-Glimmer), oder S.

Ganz besonders bevorzugt sind hierbei folgende Materialien: Mikanite (d. h. insbesondere Glimmerbruchstücke, die mit Kunstharz zu großen Glinunerfolien verpresst und verbacken werden) mit hohen Wärmeleitwi-derständen.

Gemäß einer bevorzugten Ausgestaltung des thermoelektrischen Moduls ist der Zwischenraum wenigstens zu 99 Vol.-% durch Material mit festem Aggregatzustand gebildet. Bevorzugt ist der Zwischenraum zu 99,9 Vol.-% durch Material mit festem Aggregatzustand gebildet. Insbesondere liegen keine gasförmigen oder flüssigen Einschlüsse in dem thermoelektrischen Modul vor.

Es wird nun ein Verfahren zur Herstellung eines rohrförmigen thermoelektrischen Moduls erläutert, das zumindest die folgenden Schritte aufweist:

a) Bereitstellen eines Innenrohrs mit einer Achse, mit einer Innenumfangsfläche und einer ersten Außenumfangsfläche, wobei an der ersten Außenumfangsfläche erste elektrische Leiterelemente angeordnet sind, die gegenüber der Innenumfangsfläche elektrisch isoliert ausgeführt sind.

b) Abwechselndes Anordnen von n-dotierten und p-dotierten Halbleiterelementen in Richtung der Achse, wobei zwischen den Halbleiterelementen jeweils eine elektrische Isolation angeordnet ist.

c) Anordnen von zweiten elektrischen Leiterelementen radial außen auf den Halbleiterelementen, so dass jeweils zwei zueinander benachbart angeordnete Halbleiterelemente außen miteinander elektrisch leitend verbunden sind, wobei insbesondere benachbart zueinander angeordnete zweite elektrische Leiterelemente durch eine elektrische Isolation oder durch eine äußere elektrische Isolation voneinander getrennt sind; wobei nach Schritt c) eine zweite Außenumfangsfläche gebildet ist.

d) Verdichten des thermoelektrischen Moduls.

Insbesondere können die Querschnitte des rohrförmigen thermoelektrischen Moduls kreisrund, elliptisch oder auch mehreckig ausgeführt sein. Insbesondere sind die n-dotierten und/oder p-dotierten Halbleiterelemente in einer Umfangsrichtung geschlossen ausgeführt, so dass sie auf die erste Außenumfangsfläche des Innenrohrs aufgeschoben werden können.

Bei einer rohrförmigen Ausgestaltung des thermoelektrischen Moduls ist bevorzugt zumindest auch ein Teil der Halbleiterelemente kreisringförmig geformt und jeweils mit einer äußeren Umfangsfläche und einer inneren Umfangsfläche mit der Heißseite bzw. mit der Kaltseite kontaktiert. Die äußere bzw. innere Umfangsfläche bildet dann jeweils die Stirnfläche des Halbleiterelementes, die die Heißseite bzw. Kaltseite des thermoelektrischen Moduls kontaktiert. Der Begriff kreisringförmig meint damit, dass das Halbleiterelement zumindest einen Abschnitt eines Kreisringes abbildet. Derartig geformte Halbleiterelemente sind insbesondere für rohrförmige thermoelektrische Module vorzuschlagen. Dabei bilden die Heißseite und die Kaltseite jeweils die äußere bzw. die innere Umfangsfläche eines Rohres, so dass insbesondere eine Doppelrohrwand gebildet ist, in deren Zwischenraum die Halbleiterelemente angeordnet sind. Ein derartig aufgebautes thermoelektrisches Modul wird von einem Kühlmittel durch einen von der Innenumfangsfläche des Innenrohres gebildeten Kanal durchströmt und von einem Abgas (oder einem anderen heißen Fluid) auf der zweiten Außenumfangsfläche überströmt (oder umgekehrt), so dass eine Temperaturdifferenz über die Doppelrohrwand erzeugbar ist.

Die Halbleiterelemente können insbesondere auch die Form eines Kreisringsegmentes aufweisen. Die Halbleiterelemente sind dann nebeneinander bzw. hintereinander entlang einer axialen Richtung des thermoelektrischen Moduls angeordnet. Die Kreisringform kann dabei insbesondere einer Kreisform entsprechen, es sind aber auch ovale Ausführungsformen möglich. Im Hinblick auf die Verschaltung der Halbleiterelemente ist es bspw. auch möglich, dass die Halbleiterelemente eine 180° Kreisringform aufweisen, die dann versetzt abwechselnd miteinander elektrisch verbunden sind.

Die elektrische Isolation ist insbesondere vor dem Schritt b) an den n-dotierten und/oder p-dotierten Halbleiterelementen bereits angeordnet, z. B. in Form einer Beschichtung. Insbesondere liegt die elektrische Isolation ebenfalls als ein in Umfangsrichtung geschlossenes einzelnes Bauelement vor, das entsprechend auf die erste Außenumfangsfläche des Innenrohrs aufgeschoben wird.

Insbesondere erfolgt das Anordnen von zweiten elektrischen Leiterelementen durch Aufschieben von entsprechend gestalteten und in Umfangsrichtung geschlossenen Ringen. Es ist insbesondere auch möglich, die zweiten elektrischen Leiterelemente infolge eines Druck- oder Sprühverfahrens auf die Halbleiterelemente aufzubringen. Gleiches gilt für eine ggf. erforderliche äußere elektrische Isolation, die die zweiten elektrischen Leiterelemente voneinander elektrisch isoliert. Die zweite äußere elektrische Isolation kann aber auch durch Beabstandung benachbarter zweiter elektrischer Leiterelemente realisiert werden.

Insbesondere ist vorgesehen, dass die in Schritt b) eingefügte elektrische Isolation auch als elektrische Isolation für die zweiten elektrischen Leiterelemente vorgesehen ist. Entsprechend werden insbesondere die Schritte b) und c) des Verfahrens wechselweise durchgeführt.

Insbesondere sind die an der ersten Außenumfangsfläche angeordneten ersten elektrischen Leiterelemente, die jeweils benachbart zueinander angeordnete Halbleiterelemente elektrisch miteinander verbinden sollen, in Richtung der Achse gegeneinander elektrisch isoliert. Diese Isolation ist insbesondere bereits in Schritt a) auf der ersten Außenumfangsfläche zwischen den ersten elektrischen Leiterelementen angeordnet.

Insbesondere erfolgt das Verdichten des thermoelektrischen Moduls durch Aufbringen eines Drucks von innen und/oder von außen über das Innenrohr bzw. über die zweite Außenumfangsfläche. Insbesondere erfolgt diese Verdichtung zusätzlich unter Temperatureinfluss, das heißt insbesondere bei Temperaturen über 150 °C.

Gemäß einer besonders vorteilhaften Ausgestaltung erfolgt während der Verdichtung eine Sinterung der einzelnen Bauteile des thermoelektrischen Moduls, so dass ggf. eine vorhandene Porosität verringert bzw. vollständig entfernt wird. Insbesondere werden durch Schritt d) (stoffschlüssige) Verbindungen zwischen den einzelnen Bauteilen des thermoelektrischen Moduls (insbesondere elektrische Leiterelemente mit Halbleiterelementen und/oder elektrische Isolation mit Halbleiterelementen) erzeugt. Stoffschlüssige Verbindungen werden alle Verbindungen genannt, bei denen die Verbindungspartner durch atomare oder molekulare Kräfte zusammengehalten werden. Sie sind gleichzeitig nicht lösbare Verbindungen, die sich nur durch Zerstörung der Verbindungsmittel trennen lassen (Löten, Schweißen, Kleben, etc.).

Gemäß einer weiteren vorteilhaften Ausgestaltung des Verfahrens wird ein Außenrohr nach Schritt c) an der zweiten äußeren Außenumfangsfläche des rohrförmigen thermoelektrischen Moduls angeordnet und erst danach die Verdichtung gemäß Schritt d) vorgenommen.

Insbesondere wird bei dem Verfahren und dem durch das Verfahren hergestellten thermoelektrischen Modul auf ein formfestes Außenrohr verzichtet. Entsprechend kann die zweite Außenumfangsfläche durch die zweiten elektrischen Leiterelemente oder durch eine zusätzlich aufgebrachte elektrische Isolationsschicht gebildet werden. Diese elektrische Isolationsschicht kann insbesondere durch den Einsatz einer verformbaren Hülle gebildet werden. Diese verformbare Hülle ist z. B. ein Schrumpfschlauch, der einerseits eine gute Wärmeleitfähigkeit und andererseits eine Elastizität aufweist, so dass Wärmedehnungen des thermoelektrischen Moduls durch die verformbare Hülle aufgenommen werden können. Die verformbare Hülle ersetzt also ein formfestes Außenrohr (und gleichzeitig ein an dem Außenrohr angeordnetes elektrisches Isolationsmaterial).

Es wird weiterhin ein Kraftfahrzeug vorgeschlagen, das zumindest eine Wärmequelle und eine Kühlung aufweist, wobei zwischen Wärmequelle und Kühlung

- ein thermoelektrisches Modul mit erfindungsgemäßen Halbleiterelementen oder
- ein durch das vorstehend erläuterte Verfahren hergestelltes thermoelektrisches Modul angeordnet ist.

Als Wärmequelle dient hier z. B. das Abgas einer Verbrennungskraftmaschine oder ein entsprechend zwischengeschaltetes Medium (Fluid, Gas), das zur Übertragung einer thermischen Energie eines Abgases hin zum thermoelektrischen Modul genutzt wird. Die Kühlung ist bspw. mit der Kühlung der Verbrennungskraftmaschine verbunden, und wird von Wasser oder einem anderen Kühlmittel durchströmt.

Es wird hier ausdrücklich festgestellt, dass das vorgeschlagene Verfahren auch unabhängig von den erfindungsgemäßen Halbleiterelementen eingesetzt werden kann. Es ist aber besonders bevorzugt, das vorgeschlagene Verfahren unter Einsatz der erfindungsgemäßen Halbleiterelemente durchzuführen. Entsprechend kann das zumindest teilweise mit erfindungsgemäßen Halbleiterelementen gebildete thermoelektrische Modul insbesondere durch das vorgeschlagene Verfahren erzeugt werden.

Die Erfindung sowie das technische Umfeld werden nachfolgend anhand der Figuren näher erläutert. Es ist darauf hinzuweisen, dass die Figuren besonders bevorzugte Ausführungsvarianten der Erfindung aufzeigen, diese jedoch nicht darauf beschränkt ist. Gleiche Gegenstände in den einzelnen Figuren werden mit gleichen Bezugszeichen bezeichnet. Es zeigen schematisch:

Fig. 1:     eine Ausführungsvariante eines Kraftfahrzeugs mit einem thermoelektrischen Generator;

Fig. 2:     eine Ausführungsvariante eines thermoelektrischen Moduls;

Fig. 3:     eine Ausführungsvariante eines Halbleiterelements;

Fig. 4:     eine weitere Ausführungsvariante eines Halbleiterelements;

Fig. 5:     eine Faser;

Fig. 6:     eine weitere Ausführungsvariante eines thermoelektrischen Moduls;

Fig. 7:     eine Ausführungsvariante eines ringförmigen Halbleiterelements;

Fig. 8:     ein Detail der weiteren Ausführungsvariante eines thermoelektrischen Moduls;

Fig. 9:     den qualitativen Verlauf des Wirkungsgrads des Wärmestroms und der elektrischen Leistung in Abhängigkeit von dem thermischen Widerstand des thermoelektrischen Moduls;

Fig. 10:    Verfahrensschritt a) des Verfahrens;

Fig. 11:    Verfahrensschritt b) des Verfahrens;

Fig. 12:    Verfahrensschritt c) des Verfahrens;

Fig. 13:    eine Verfahrensvariante des Verfahrens;

Fig. 14:    Verfahrensschritt d) des Verfahrens.

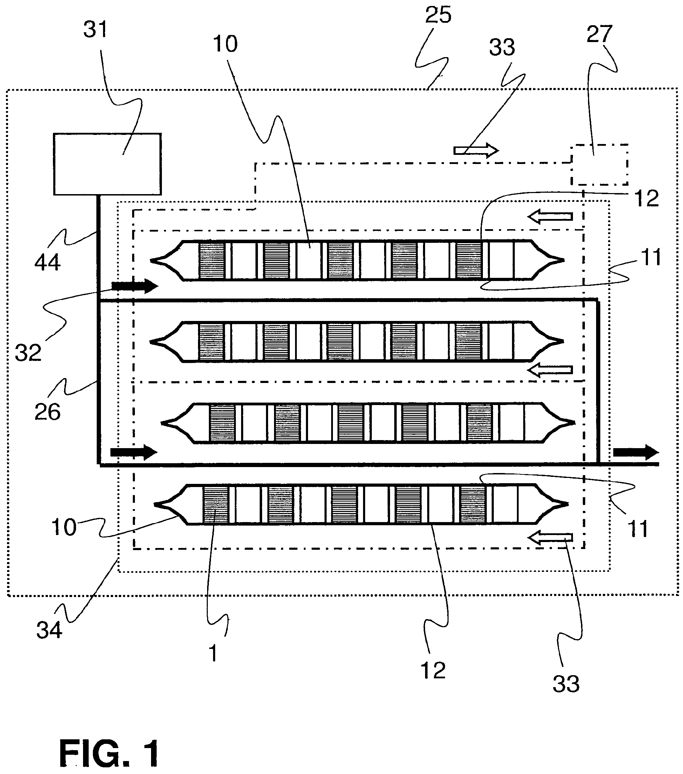

Fig. 1 zeigt eine Ausführungsvariante eines Kraftfahrzeugs 25 mit einem thermoelektrischen Generator 34. Das Kraftfahrzeug 25 weist eine Verbrennungskraftmaschine 31 mit einer Abgasanlage 44 auf. Ein Abgas 32 durchströmt die Abgasanlage 44. Die Abgasanlage 44 dient hier als Wärmequelle 26 für den thermoelektrischen Generator 34. Der thermoelektrische Generator 34 wird durch mehrere thermoelektrische Module 10 gebildet, die parallel zueinander angeordnet sind. Das Abgas 32 wird zwischen den thermoelektrischen Modulen 10 hindurchgeleitet, so dass an dem thermoelektrischen Modul 10 eine Heißseite 11 gebildet ist. Das Kraftfahrzeug 25 weist weiterhin eine Kühlung 27 auf, die die thermoelektrischen Module 10 mit einem Kühlmittel 33 beaufschlagt, so dass an dem thermoelektrischen Modul 10 auch eine Kaltseite 12 gebildet ist. Die thermoelektrischen Module 10 weisen Halbleiterelemente 1 auf.

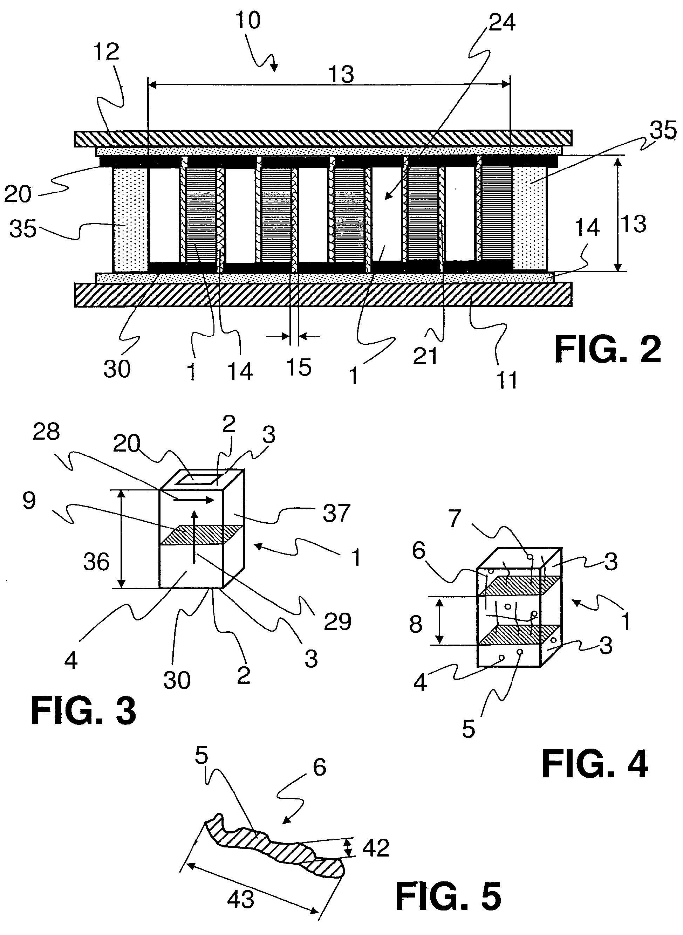

Fig. 2 zeigt eine Ausführungsvariante eines thermoelektrischen Moduls 10, hier in einer plattenförmigen Ausführung. Das thermoelektrische Modul 10 weist eine Kaltseite 12 und eine gegenüberliegend angeordnete Heißseite 11 auf. Zwischen Heißseite 11 und Kaltseite 12 ist ein Zwischenraum 13 gebildet, der an den Enden des thermoelektrischen Moduls 10 durch Abschlusselemente 35 begrenzt ist. Innerhalb des Zwischenraums 13 sind Halbleiterelemente 1 angeordnet. Die Halbleiterelemente 1 sind durch erste elektrische Leiterelemente 20 und zweite elektrische Leiterelemente 30 elektrisch leitend wechselweise miteinander verbunden. Das Isolationsmaterial 14 zwischen den Halbleiterelementen 1 weist eine erste Dicke 15 auf. Das Isolationsmaterial 14 bildet entsprechend eine elektrische Isolation 21 der Halbleiterelemente 1. Weiterhin ist ein Isolationsmaterial 14 zwischen dem ersten elektrischen Leiterelement 20 und der Kaltseite 12 sowie zwischen den zweiten elektrischen Leiterelementen 30 und der Heißseite 11 ausgebildet. Dieses Isolationsmaterial 14 an der Heißseite 11 und an der Kaltseite 12 wird hier der Heißseite 11 bzw. der Kaltseite 12 zugerechnet und damit nicht dem Zwischenraum 13. Der Zwischenraum 13 ist durch Material 24, nämlich elektrische Isolation 21 bildendes Isolationsmaterial 14, erste elektrische Leiterelemente 20, zweite elektrische Leiterelemente 30 und Halbleiterelemente 1, gefüllt. Der Zwischenraum 13 ist wenigstens zu 99 Vol.-% durch Material 24 mit festem Aggregatzustand gefüllt. Insbesondere liegen keine gasförmigen oder flüssigen Einschlüsse in dem thermoelektrischen Modul 10 vor.
Fig. 3 zeigt eine Ausführungsvariante eines quaderförmigen Halbleiterelements 1. Das Halbleiterelement 1 erstreckt sich zwischen zwei einander gegenüberliegenden Enden 3 und wird unter anderem durch ein Halbleitermaterial 4 gebildet. Die Enden 3 bilden Stirnflächen 2, an denen erste elektrische Leiterelemente 20 und zweite elektrische Leiterelemente 30 angeordnet werden. Das Halbleiterelement 1 weist eine Höhe 36 auf. Das Halbleiterelement 1 wird seitlich durch Seitenflächen 37 begrenzt. Parallel zu den Enden 3 weist das Halbleiterelement Querschnitte 9 auf. Diese Querschnitte 9 verlaufen in einer ersten Richtung 28 parallel zu den Stirnflächen 2 der Enden 3. Eine zweite Richtung 29 erstreckt sich quer zu der ersten Richtung 28.
Fig. 4 zeigt eine weitere Ausführungsvariante eines quaderförmigen Halbleiterelements. Das Halbleiterelement 1 weist einen mittleren Bereich 8 und Enden 3 auf. Das Halbleiterelement 1 weist neben dem Halbleitermaterial 4 ein Fremdmaterial 5 auf, das in Form von Fasern 6 und Körnern 7 vorliegt.
Fig. 5 zeigt ein Fremdmaterial 5 in Form einer Faser 6. Hier beträgt das Verhältnis von Länge 43 zu zweiter Dicke 42 zwei oder mehr.

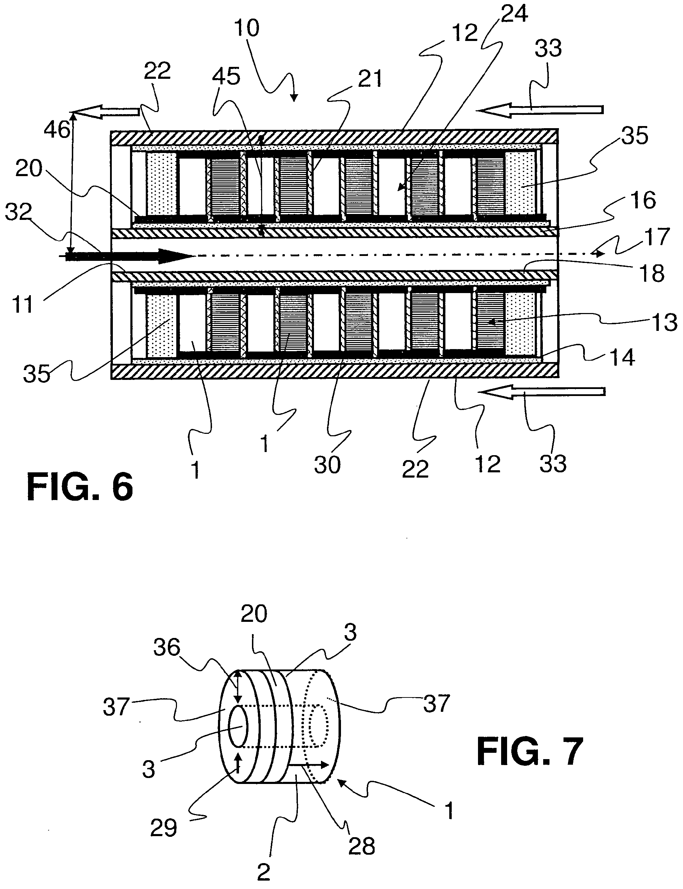

Fig. 6 zeigt eine rohrförmige Ausführungsvariante eines thermoelektrischen Moduls 10. Dieses rohrförmige thermoelektrische Modul 10 wird hier außen von einem Kühlmittel 33 überströmt, so dass das Außenrohr 22 die Kaltseite 12 des thermoelektrischen Moduls 10 bildet. Im Inneren wird das thermoelektrische Modul 10 von einem Abgas 32 durchströmt, so dass das Innenrohr 16 die Kaltseite 12 des thermoelektrischen Moduls bildet. Innenrohr 16 und Außenrohr 22 erstrecken sich hier koaxial zueinander in Richtung einer Achse 17. Das Innenrohr 16 weist eine Innenumfangsfläche 18 auf, die von dem Abgas 32 beaufschlagt wird. Das thermoelektrische Modul 10 wird seitlich von Abschlusselementen 35 begrenzt, die den Zwischenraum 13 zwischen Außenrohr 22 und Innenrohr 16 nach außen abschließen. In dem Zwischenraum 13 sind Halbleiterelemente 1 und elektrische Isolationen 21 wechselweise hintereinander in Richtung der Achse 17 angeordnet. Im Bereich des Innenrohrs 16 sind die Halbleiterelemente 1 über erste elektrische Leiterelemente 20 elektrisch leitend miteinander verbunden. Im Bereich des Außenrohrs 22 sind die Halbleiterelemente 1 elektrisch leitend über zweite elektrische Leiterelemente 30 miteinander verbunden. Die ersten elektrischen Leiterelemente 20 sind von dem Innenrohr 16 und die zweiten elektrischen Leiterelementen 30 von dem Außenrohr 22 durch elektrisches Isolationsmaterial 14 getrennt. Der Zwischenraum 13 ist durch Material 24, nämlich elektrische Isolation 21 bildendes Isolationsmaterial 14, erste elektrische Leiterelemente 20, zweite elektrische Leiterelemente 30 und Halbleiterelemente 1, gefüllt. Der Zwischenraum 13 ist wenigstens zu 99 Vol.-% durch Material 24 mit festem Aggregatzustand gefüllt. Insbesondere liegen keine gasförmigen oder flüssigen Einschlüsse in dem thermoelektrischen Modul 10 vor.

Die elektrische Isolation 14 zwischen den Leiterelementen und dem Innenrohr 16 bzw. Außenrohr 22 ermöglicht einen guten Wärmeübergang von der Heißseite 11 bzw. der Kaltseite 12 hin zu den Halbleiterelementen 1. Die elektrische Isolation 21 hat gleichzeitig gute thermische Isolationseigenschaften, so dass eine Wärmeübertragung von der Heißseite 11 zur Kaltseite 12 über die elektrische Isolation 21 weitgehend unterbunden wird. Zusätzlich wird die Wärmeübertragung von der Heißseite 11 zur Kaltseite 12 durch das in den Halbleiterelementen 1 hier nicht gezeigte Fremdmaterial 5 begrenzt. Dadurch kann die Temperaturdifferenz 45 zwischen der Heißseite 11 und der Kaltseite 12 zur Stromerzeugung des thermoelektrischen Moduls 10 effizient genutzt werden. Die Temperaturdifferenz 45 ist damit regelmäßig geringer als die Gesamttemperaturdifferenz 46, die durch die Temperatur des Abgases 32 auf der Heißseite 11 und durch die Temperatur des Kühlmittels 33 auf der Kaltseite 12 gebildet wird. Der innerhalb des thermoelektrischen Moduls 10 erzeugte elektrische Strom wird im Bereich der Abschlusselemente 35 über die ersten elektrischen Leiterelemente 20 oder zweiten elektrischen Leiterelemente 30 nach außen abgeführt.

Fig. 7 zeigt eine Ausführungsvariante eines ringförmigen Halbleiterelements. Dieses ringförmige Halbleiterelement 1 kann in dem rohrförmigen thermoelektrischen Modul 10 gemäß Fig. 6 eingesetzt werden. Das hier gezeigte Halbleiterelement 1 weist eine ringförmige Gestalt auf, so dass die Enden 3 durch eine äußere Umfangsfläche bzw. durch eine innere Umfangsfläche des ringförmigen Halbleiterelements 1 gebildet werden. Die Höhe 36 erstreckt sich von einem Ende 3 zum anderen Ende 3 des Halbleiterelements 1. Das Halbleiterelement 1 wird seitlich von Seitenflächen 37 begrenzt. Die Enden 3 bilden die Stirnflächen 2 des Halbleiterelements 1. Querschnitte 9 (hier nicht gezeigt) durch das Halbleiterelement 1 verlaufen parallel zu den Stirnflächen 2 an den Enden 3 des Halbleiterelements 1. Die erste Richtung 28 erstreckt sich ebenfalls parallel zu den Stirnflächen 2, während die zweite Richtung 29 sich quer zu der ersten Richtung 28 erstreckt. An den Stirnflächen 2 sind erste elektrische Leiterelemente 20 und zweite elektrische Leiterelemente 30 (hier an der Innenumfangsfläche, nicht gezeigt) angeordnet.

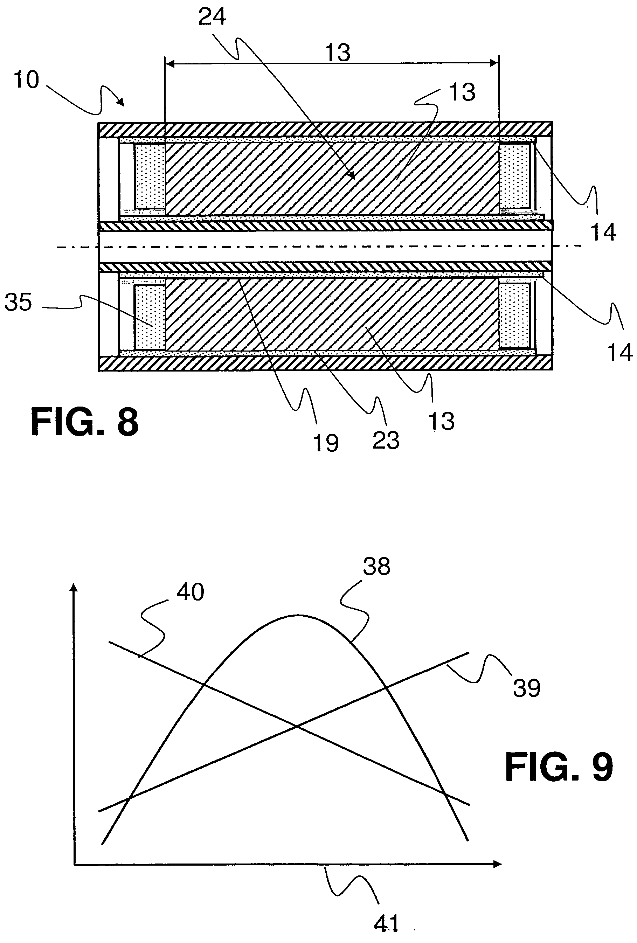

Fig. 8 zeigt ein Detail der rohrförmigen Ausführungsvariante des thermoelektrischen Moduls 10. Das thermoelektrische Modul 10 weist zwischen den Abschlusselementen 35, der ersten Außenumfangsfläche 19 und der zweiten Außenumfangsfläche 23 den Zwischenraum 13 auf. Das elektrisch isolierende Isolationsmaterial 14 an der Heißseite 11 und der Kaltseite 12 wird nicht dem Zwischenraum 13 zugerechnet. Der Zwischenraum 13 ist wenigstens zu 99 Vol.-% durch Material 24 mit festem Aggregatzustand gefüllt.

Fig. 9 zeigt den Verlauf des Wirkungsgrads 39 des Wärmestroms 40 und der elektrischen Leistung 38 in Abhängigkeit von dem thermischen Widerstand 41 des thermoelektrischen Moduls 10. Der thermische Widerstand 41 ist auf der horizontalen Achse aufgetragen. Mit steigendem thermischem Widerstand 41 des thermoelektrischen Moduls 10 erhöht sich die für die Stromerzeugung nutzbar machende Temperaturdifferenz 45 zwischen Heißseite 11 und Kaltseite 12 des thermoelektrischen Moduls 10. Der thermoelektrische Wirkungsgrad 39 profitiert näherungsweise linear von einer steigenden Temperaturdifferenz 45. Dafür sinkt jedoch der fließende Wärmestrom 40 durch das thermoelektrische Modul 10, da sich mit steigendem thermischem Widerstand 41 des thermoelektrischen Moduls 10 auch der Gesamtwiderstand (Summe $R_{konvektiv}$ und $R_{Modul}$) erhöht. Es gibt somit ein Leistungsmaximum der Gesamtanordnung in Abhängigkeit des thermischen Widerstands 41. Näherungsweise kann man ansetzen, dass die elektrische Leistung 38 dann maximal ist, wenn die Hälfte der Gesamttemperaturdifferenz 46 (Abgas 32 zu Kühlmittel 33) über dem thermoelektrischen Modul 10 - also zwischen Heißseite 11 und Kaltseite 12 - abfällt (Temperaturdifferenz 45).

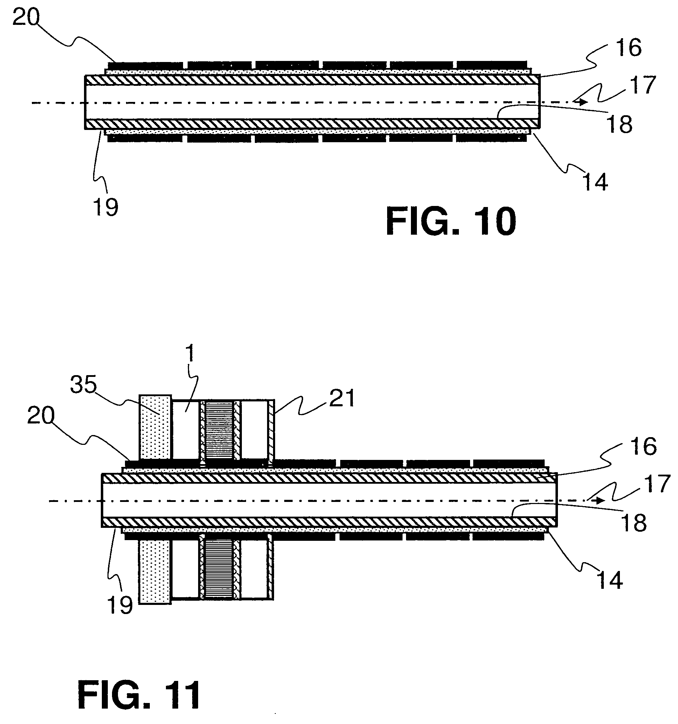

Fig. 10 zeigt Verfahrensschritt a) des Verfahrens. Es wird ein Innenrohr 16, das sich entlang einer Achse 17 erstreckt, mit einer Innenumfangsfläche 18 und einer ersten Außenumfangsfläche 19 bereitgestellt. An der ersten Außenumfangsfläche 19 sind erste elektrische Leiterelemente 20 angeordnet, die gegenüber der Innenumfangsfläche 18 durch ein Isolationsmaterial 14 elektrisch isoliert ausgeführt sind.

Fig. 11 zeigt Verfahrensschritt b) des Verfahrens. Auf der Anordnung gemäß Fig. 10 sind nun Abschlusselemente 35 und danach anschließend Halbleiterelemente 1 (n-dotiert und p-dotiert) wechselweise nebeneinander angeordnet. Zwischen den Halbleiterelementen 1 ist jeweils eine elektrische Isolation 21 angeordnet. Die Halbleiterelemente 1 und die elektrische Isolation 21 werden insbesondere als ringförmige Elemente auf die Anordnung gemäß Fig. 10 aufgeschoben.

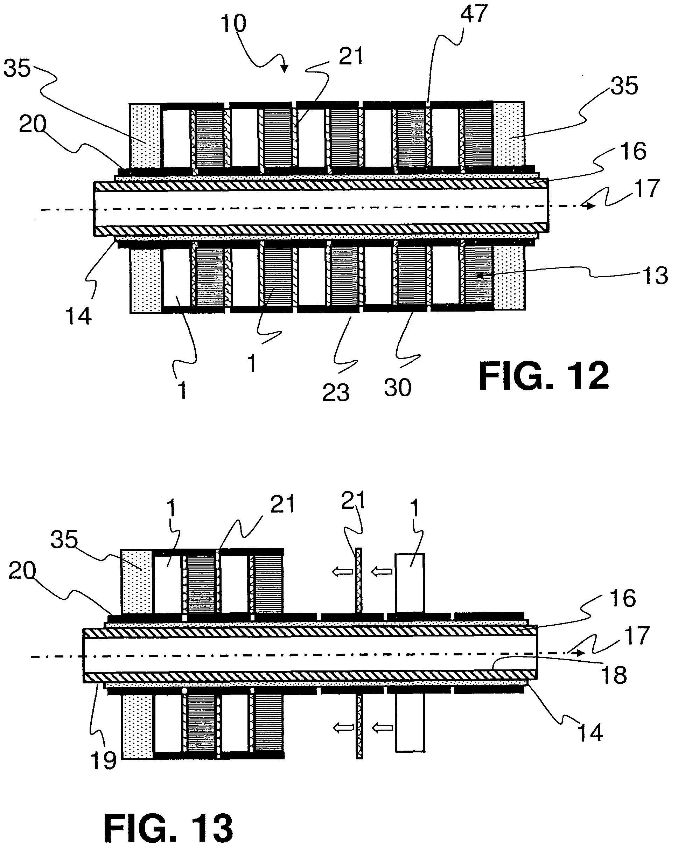

Fig. 12 zeigt Verfahrensschritt c) des Verfahrens. Hier ist bereits ein thermoelektrisches Modul 10 gebildet. Auf dem Innenrohr 16 sind nun Abschlusselemente 35 und n- und p-dotierte Halbleiterelemente 1 angeordnet. Die Halbleiterelemente 1 sind innen durch erste elektrische Leiterelemente 20 wechselweise elektrisch leitend verbunden. Korrespondierend dazu sind radial außen auf den Halbleiterelementen 1 zweite elektrische Leiterelemente 30 angeordnet. Diese können durch eine äußere elektrische Isolation 47 voneinander elektrisch isoliert sein. Die zweiten elektrischen Leiterelemente 30 bilden entsprechend (gemeinsam mit der äußeren elektrischen Isolation 47) eine zweite Außenumfangsfläche 23. Zwischen der zweiten Außenumfangsfläche 23 und dem auf dem Innenrohr 16 angeordneten Isolationsmaterial 14 und den Abschlusselementen 35 bildet sich entsprechend der Zwischenraum 13 des thermoelektrischen Moduls 10 aus.

Fig. 13 zeigt eine weitere Variante des Verfahrensschritts b) des Verfahrens. Auf die Anordnung gemäß Fig. 10 werden in Richtung der Achse 17 wechselweise Halbleiterelemente 1 und elektrische Isolationen 21 aufgeschoben. Durch die elektrischen Isolationen 21 werden die zweiten elektrischen Leiterelemente 30 in Richtung der Achse 17 voneinander elektrisch isoliert. Es werden also unterschiedliche elektrische Isolationen 21 eingesetzt, jeweils in Abhängigkeit davon, ob benachbarte Halbleiterelemente 1 durch zweite elektrische Leiterelemente 30 miteinander verbunden werden.

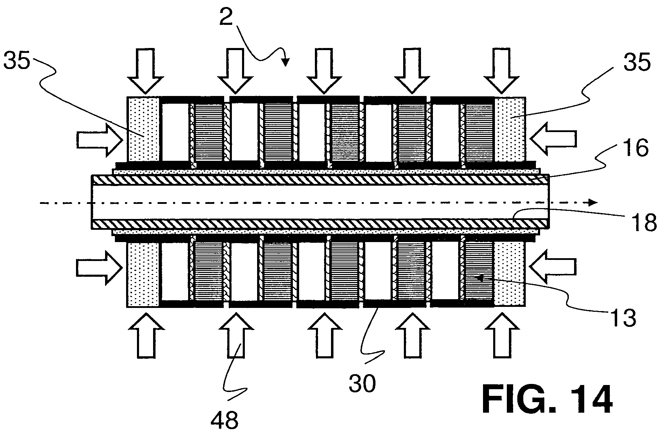

Fig. 14 zeigt Verfahrensschritt d) des Verfahrens. Das thermoelektrische Modul 10 wird durch Aufbringen eines Drucks 48 und ggf. unter Beaufschlagung einer bestimmten Temperatur verdichtet.

Bezugszeichenliste

| | |
|---|---|
| 1 | Halbleiterelement |
| 2 | Stirnfläche |
| 3 | Ende |
| 4 | Halbleitermaterial |
| 5 | Fremdmaterial |
| 6 | Faser |
| 7 | Korn |
| 8 | Bereich |
| 9 | Querschnitt |
| 10 | Thermoelektrisches Modul |
| 11 | Heißseite |
| 12 | Kaltseite |
| 13 | Zwischenraum |
| 14 | Isolationsmaterial |
| 15 | Erste Dicke |
| 16 | Innenrohr |
| 17 | Achse |
| 18 | Innenumfangsfläche |
| 19 | Erste Außenumfangsfläche |
| 20 | Erste elektrische Leiterelemente |
| 21 | Elektrische Isolation |
| 22 | Außenrohr |
| 23 | zweite Außenumfangsfläche |
| 24 | Material |
| 25 | Kraftfahrzeug |
| 26 | Wärmequelle |
| 27 | Kühlung |
| 28 | Erste Richtung |
| 29 | Zweite Richtung |
| 30 | Zweite elektrische Leiterelemente |
| 31 | Verbrennungskraftmaschine |
| 32 | Abgas |
| 33 | Kühlmittel |
| 34 | Thermoelektrischer Generator |
| 35 | Abschlusselement |
| 36 | Höhe |
| 37 | Seitenfläche |

38    Elektrische Leistung
39    Wirkungsgrad
40    Wärmestrom
41    Thermischer Widerstand
42    Zweite Dicke
43    Länge
44    Abgasanlage
45    Temperaturdifferenz
46    Gesamttemperaturdifferenz
47    Äußere elektrische Isolation
48    Druck

**Patentansprüche**

1.  Halbleiterelement (1) zum Einsatz in einem thermoelektrischen Modul (10), wobei das Halbleiterelement (1) einander gegenüberliegende Enden (3) aufweist und aus einem n-dotierten oder p-dotierten Halbleitermaterial (4) und mindestens einem Fremdmaterial (5) gebildet ist, wobei das Fremdmaterial (5) mit dem Halbleitermaterial (4) vermischt ist und das Fremdmaterial (5) einen Anteil von 5 bis 75 Vol.-% an dem Halbleiterelement (1) bildet; wobei das mindestens eine Fremdmaterial (5) in Form von Fasern (6) und Körnern (7) vorliegt, **dadurch gekennzeichnet dass** Körner (7) und Fasern (6) in dem Halbleiterelement (1) unterschiedlich verteilt sind, wobei Körner (7) an den Enden (3) des Halbleiterelements (1) mit einem höheren Anteil als die Fasern (6) vorliegen und/oder die Fasern (6) mit einem höheren Anteil als die Körner (7) in einem mittleren Bereich (8) zwischen den Enden (3) des Halbleiterelements (1) vorliegen.

2.  Halbleiterelement (1) nach Patentanspruch 1, wobei das mindestens eine Fremdmaterial (5) in einem Temperaturbereich von 20 bis 600 °C zumindest eine Eigenschaft aus der folgenden Gruppe aufweist:

    - höhere Zugfestigkeit $R_m$ und/oder Streckgrenze $R_{p0,2}$ als das Halbleitermaterial (4),
    - geringere spezifische Wärmeleitfähigkeit als das Halbleitermaterial (4),
    - geringere elektrische Leitfähigkeit als das Halbleitermaterial (4).

3.  Halbleiterelement (1) nach Patentanspruch 1 oder 2, wobei der Anteil von Körnern (7) bei dem Fremdmaterial (5) zumindest 30 Vol.-% beträgt.

4.  Halbleiterelement (1) nach einem der vorhergehenden Patentansprüche, wobei das mindestens eine Fremdmaterial (5) zumindest in Form von Fasern (6) vorliegt und die Fasern (6) im Wesentlichen in mindestens einer ersten Richtung (28) parallel zu den Enden (3) und/oder in einer zweiten Richtung (29), die quer zu der ersten Richtung (28) verläuft, angeordnet sind.

5.  Halbleiterelement (1) nach einem der vorhergehenden Patentansprüche, wobei jeder parallel zu den Enden (3) verlaufende Querschnitt (9) des Halbleiterelements (1) einen Anteil von Fremdmaterial (5) aufweist, der in einem Bereich zwischen 25 % und 75 % liegt.

**Claims**

1.  Semiconductor element (1) for use in a thermoelectric module (10), wherein the semiconductor element (1) has mutually opposite ends (3) and is formed from an n-doped or p-doped semiconductor material (4) and at least one foreign material (5), wherein the foreign material (5) is mixed with the semiconductor material (4) and the foreign material (5) makes up a fraction of 5 to 75 vol% of the semiconductor element (1); wherein the at least one foreign material (5) is present in the form of fibers (6) and grains (7), **characterized in that** grains (7) and fibers (6) are distributed differently in the semiconductor element (1), wherein grains (7) are present in a greater fraction than the fibers (6) at the ends (3) of the semiconductor element (1) and/or the fibers (6) are present in a greater fraction than the grains (7) in a central region (8) between the ends (3) of the semiconductor element (1).

2.  Semiconductor element (1) according to Patent Claim 1, wherein the at least one foreign material (5) has, in a temperature range from 20 to 600°C, at least one characteristic from the following group:

- greater tensile strength $R_m$ and/or yield strength $R_{p0.2}$ than the semiconductor material (4),
- lower specific thermal conductivity than the semiconductor material (4),
- lower electrical conductivity than the semiconductor material (4).

**3.** Semiconductor element (1) according to Patent Claim 1 or 2, wherein the fraction of grains (7) in the foreign material (5) amounts to at least 30 vol%.

**4.** Semiconductor element (1) according to one of the preceding patent claims, wherein the at least one foreign material (5) is present at least in the form of fibers (6) and the fibers (6) are arranged substantially in at least one first direction (28) parallel to the ends (3) and/or in a second direction (29) that runs transversely with respect to the first direction (28).

**5.** Semiconductor element (1) according to one of the preceding patent claims, wherein every cross section (9) of the semiconductor element (1) running parallel to the ends (3) has a fraction of foreign material (5) which lies in a range between 25% and 75%.

## Revendications

**1.** Élément semiconducteur (1) destiné à être utilisé dans un module thermoélectrique (10), l'élément semiconducteur (1) possédant des extrémités (3) mutuellement opposées et étant formé par un matériau semiconducteur (4) dopé N ou dopé P et au moins un matériau étranger (5), le matériau étranger (5) étant mélangé au matériau semiconducteur (4) et le matériau étranger (5) formant une part de 5 à 75 % volumiques de l'élément semiconducteur (1), l'au moins un matériau étranger (5) étant présent sous la forme de fibres (6) et de grains (7), **caractérisé en ce que** les grains (7) et les fibres (6) sont distribués différemment dans l'élément semiconducteur (1), les grains (7) étant présents aux extrémités (3) de l'élément semiconducteur (1) dans une part supérieure à celle des fibres (6) et/ou les fibres (6) étant présentes dans une zone centrale (8) entre les extrémités (3) de l'élément semiconducteur (1) dans une part supérieure à celle des grains (7).

**2.** Élément semiconducteur (1) selon la revendication 1, avec lequel l'au moins un matériau étranger (5) possède, dans une plage de températures de 20 à 600 °C, au moins une caractéristique du groupe suivant:

- une résistance à la traction $R_m$ et/ou une limite élastique $R_{p0,2}$ supérieure à celle du matériau semiconducteur (4),
- une conductivité thermique spécifique inférieure à celle du matériau semiconducteur (4),
- une conductivité électrique inférieure à celle du matériau semiconducteur (4).

**3.** Élément semiconducteur (1) selon la revendication 1 ou 2, avec lequel la part de grains (7) au niveau du matériau étranger (5) est au moins égale à 30 % volumiques.

**4.** Élément semiconducteur (1) selon l'une des revendications précédentes, avec lequel l'au moins un matériau étranger (5) est présent au moins sous la forme de fibres (6), et les fibres (6) sont disposées sensiblement dans au moins une première direction (28) parallèle aux extrémités (3) et/ou dans une deuxième direction (29) qui s'étend transversalement à la première direction (28).

**5.** Élément semiconducteur (1) selon l'une des revendications précédentes, avec lequel chaque section transversale (9) de l'élément semiconducteur (1) qui s'étend parallèlement aux extrémités (3) possède une part de matériau étranger (5) qui est comprise dans une plage entre 25 % et 75 %.

**FIG. 1**

**FIG. 2**

**FIG. 3**

**FIG. 4**

**FIG. 5**

**FIG. 6**

**FIG. 7**

**FIG. 8**

**FIG. 9**

**FIG. 10**

**FIG. 11**

## FIG. 12

## FIG. 13

FIG. 14

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20060118158 A1
- WO 2010117875 A2